## Europäisches Patentamt

## European Patent Office

## Office européen des brevets

(19)

(11) Veröffentlichungsnummer: **0 030 383**
**B1**

(12)

# EUROPÄISCHE PATENTSCHRIFT

(45) Veröffentlichungstag der Patentschrift:
**25.04.84**

(51) Int. Cl.³: **G 01 R 29/26,** G 01 R 27/28

(21) Anmeldenummer: **80107676.1**

(22) Anmeldetag: **05.12.80**

(54) **Verfahren zur Ermittlung der Quantisierungsverzerrungen einer PCM-Übertragungseinrichtungen.**

(30) Priorität: **10.12.79 DE 2949600**

(43) Veröffentlichungstag der Anmeldung:
**17.06.81 Patentblatt 81/24**

(45) Bekanntmachung des Hinweises auf die Patenterteilung:
**25.04.84 Patentblatt 84/17**

(84) Benannte Vertragsstaaten:
**BE DE FR GB IT NL**

(56) Entgegenhaltungen:
**DE - B - 1 949 132**
**US - A - 3 486 112**
**US - A - 3 619 774**

**DE-Zeitschrift "Frequenz" 26 (1972) 5, S. 118-123**

(73) Patentinhaber: **SIEMENS AKTIENGESELLSCHAFT,**
**Berlin und München Wittelsbacherplatz 2,**
**D-8000 München 2 (DE)**

(72) Erfinder: **Fink, Helmuth, Ing. grad.,**
**Wiesentfelserstrasse 74, D-8000 München 60 (DE)**
Erfinder: **Wieland, Hansjürgen, Ing. grad.,**
**Kölnerstrasse 12, D-6100 Darmstadt (DE)**

## Verfahren zur Ermittlung der Quantisierungsverzerrungen einer PCM-Übertragungseinrichtung

Die Erfindung bezieht sich auf ein Verfahren zur Ermittlung der von einer PCM-Übertragungseinrichtung bewirkten Quantisierungsverzerrung eines übertragenen Signals in Abhängigkeit vom Pegel dieses Signals, bei dem die Übertragungseinrichtung senderseitig mit einem sinusförmigen Signal einer gegebenen Frequenz beaufschlagt wird, empfangsseitig zwei parallele Kanäle vorgesehen werden, von denen der eine auf die gegebene Frequenz und der andere auf ein die gegebene Frequenz nicht enthaltendes Frequenzband abgestimmt wird, sende- und empfangsseitig eine gleichzeitige gegenläufige Pegeleinstellung derart vorgenommen wird, daß der Pegel in den beiden Kanälen bei einer Veränderung des Pegels des sinusförmigen Signals im wesentlichen konstant bleibt, und die sich für einen jeweils unterschiedlichen Pegel des sinusförmigen Signals ergebenden Ausgangspegel der beiden Kanäle gemessen und zur Ermittlung der eine Periodizität aufweisenden Abhängigkeit der Quantisierungsverzerrung von dem Pegel des sinusförmigen Signals verwendet werden.

Es ist bereits bekannt (Zeitschrift »Frequenz« 26 (1972), Seiten 118—123, »Rauschklirrmessungen an PCM-Systemen«), daß bei einem Verfahren dieser Art die Pegeleinstellungen miteinander gekoppelt sind. Die somit erhaltene Meßkurve für den Signal-(Quantisierungs-)-Geräuschabstand weist in Abhängigkeit vom Pegel des senderseitigen Signals in weiten Bereichen eine erhebliche Streuung der Meßwerte mit periodischem Charakter auf, wobei eine Verminderung des Einflusses der Streuung hier mit erheblichem Meßaufwand (beispielsweise äußerst feingestufte Messung oder Sendesignal mit statistischer Amplituden- und Frequenzverteilung) Meßdauer erreicht werden soll.

Durch »telcom report«, 2. Jahrgang (1979), Beiheft Digital-Übertragungstechnik sind durch die Seiten 165 bis 169 Meßverfahren für die PCM-Übertragung bekannt, wobei die Bestimmung der Quantisierungsverzerrungen nach zwei verschiedenen Meßverfahren durchgeführt werden kann: In einem Fall wird ein Sinussignal als Testsignal verwendet, im anderen Fall ein bandbegrenztes Rauschsignal. Die Anteile des Signals S und der Verzerrungsleistung Q werden über getrennte selektive Pfade gemessen.

Bei der empfangsseitigen Auswertung tritt ein Problem insofern auf, als bei einer sendeseitigen Pegeländerung jeweils erst die Einschwingzeit z. B. der Filterschaltungen empfangsseitig abgewartet werden muß, bis jeweils exakte Meßwerte vorliegen. Dies bedingt vor allem bei einer größeren Zahl von Einzelmessungen eine unerwünschte erhebliche Vergrößerung der gesamten Meßdauer; dies stört besonders bei der automatischen Leitungsmessung.

Der Erfindung liegt die Aufgabe zugrunde, die Meßzeit bei der Messung der Quantisierungsverzerrung zu verkürzen. Gemäß der Erfindung, welche sich auf ein Verfahren der eingangs genannten Art bezieht, wird dies dadurch erreicht, daß die senderseitige Einstellung des Pegels des sinusförmigen Signals in solchen Stufen erfolgt, daß die Meßwerte für die Quantisierungsverzerrung etwa im Abstand der halben Periodizität der Abhängigkeit der Quantisierungsverzerrung von diesem Pegel erhalten werden, und jeweils der Mittelwert zwischen zwei benachbarten Meßwerten gebildet wird.

Da auf diese Weise bei der Messung jeweils etwa gleiche Pegelwerte vorliegen und zwar unabhängig davon, welche Pegel auf der Sendeseite tatsächlich eingestellt werden, kann die »Einschwingzeit« bei jeder Pegeländerung sehr klein gehalten werden bzw. ganz entfallen.

Weiterbildungen der Erfindung sind in den Unteransprüchen wiedergegeben.

Die Erfindung wird nachfolgend an Hand von Zeichnungen näher erläutert. Es zeigt

F i g . 1 ein erstes Ausführungsbeispiel zur Erläuterung der Erfindung,

F i g . 2 ein weiteres Ausführungsbeispiel zur Erläuterung der Erfindung,

F i g . 3 ein Ausführungsbeispiel, bei dem rückwärts gemessen wird und

F i g . 4 ein Pegeldiagramm.

Bei dem Blockschaltbild nach F i g . 1 sind die verschiedenen Schaltungsteile der Sendeseite jeweils mit den Buchstaben S und die Schaltungsteile der Empfangsseite mit dem Buchstaben E bezeichnet. Die Sendeseite enthält einen durchstimmbaren Oszillator SO, dessen Frequenz über das gesamte interessierende Meßband durchstimmbar ist. Die Messung erfolgt jedoch im einzelnen bei jeweils einer bestimmten Frequenz z. B. bei 430 Hz innerhalb eines Fernsprechkanals, der von z. B. von 0,2 kHz bis 3,4 kHz reichen kann. Dem Ausgang dieses sendeseitigen Oszillators SO ist ein einstellbares Dämpfungsglied SD nachgeschaltet, durch das am Ausgang ein bestimmter jeweils in Stufen oder stetig veränderbarer Pegelwert an eine Übertragungsstrecke PL für PCM-Übertragung abgegeben wird. Diese Übertragungsstrecke PL enthält entsprechende, hier nicht näher dargestellte Einrichtungen, welche die am Ausgang des Dämpfungsgliedes SD vorhandenen Signale entsprechend codieren und über die Übertragungsleitung PL zum Empfangsort übertragen, wo eine Umsetzung, d. h. Decodierung vorgenommen wird, so daß am Eingang des empfangsseitigen Dämpfungsgliedes ED wieder Analogsignale vorliegen. Das Dämpfungsglied ED ist ebenso wie das sendeseitige Dämpfungsglied SD durch eine entsprechende Steuereinrichtung SST bzw. EST einstellbar. Der Ausgang des empfangsseitigen Dämpfungsgliedes ED ist zwei parallelen Meßzweigen zugeführt. Im ersten Meßzweig ist die Auslegung des Durchlaßbandes so gewählt, daß die bestimmte Frequenz, d. h. die Frequenz des Sendeoszillators SO hier mit durchgelassen wird.

Gegebenenfalls kann der Durchlaßbereich auch so breit sein wie ein ganzes Sprachband, z. B. 0,2 bis 3,4 kHz.

Dagegen wird im zweiten Meßzweig durch das Filter EFQ das Sendesignal, also z. B. die Frequenz 430 Hz ausgefiltert und nur in Bereichen außerhalb dieser bestimmten Frequenz oder des bestimmten Frequenzbandes gemessen.

Auf diese Weise liegt im zweiten Meßzweig durch die Wirkung des Filters EFQ jeweils ein signal an, das mit zunehmender Quantisierungsverzerrung der Übertragungsleitung PL größer wird.

Durch einen von der empfangsseitigen Steuerschaltung EST betätigbaren Umschalter EUS wird jeweils abwechselnd das Ausgangssignal eines der beiden Meßzweige einem Empfangsgleichrichter EG zugeführt, wobei der Pegel des Ausgangssignals des Gleichrichters EG ein Maß für die Größe der Signalspannungen jeweils der beiden Meßzweige darstellt. Dieses Meßergebnis wird zur Auswertung entweder am Empfangsort unmittelbar dargestellt, oder aber (wie hier gezeichnet) zur Sendeseite zurückübertragen. Hierzu ist auf der Empfangsseite ein Spannungs-Frequenzumsetzer EUF vorgesehen, der das erhaltene Signal in frequenzcodierter Form zur Sendeseite zurücküberträgt, wo eine entsprechende Rückumsetzung durch den Frequenz Spannungsumsetzer SFU erfolgt. Anstelle der dargestellten Spannungs-Frequenz-Umsetzung können auch andere Arten der Codierung der empfangsseitigen Meßwerte angewendet werden, z. B. in Form von mehrfachen Frequenzcodierungen (MFC) oder entsprechende Codierung in Codeworten. Die erhaltenen Meßwerte werden bei dem vorliegenden Beispiel einer sendeseitig angeordneten Auswerteschaltung SAW zugeführt. Dort können die Empfangswerte der beiden Meßzweige vorteilhaft zunächst logarithmiert und dann durch Differenzbildung dieser logarithmischen Werte der S/Q-Wert ermittelt werden. Dabei bedeutet S den Sendepegel d. h. dieser Wert entspricht dem Ausgangssignal des ersten Meßzweiges, während Q denjenigen Pegel darstellt, welcher aus der Quantisierungsverzerrung der Übertragungsstrecke PL und der zugehörigen Einrichtungen herrührt. Die so erhaltenen Werte können in geeigneter Form z. B. über Drucker, Sichtgeräte usw. angezeigt werden.

Bei der dargestellten Meßschaltung ergibt sich ein Problem, welches durch das Zeit- bzw. Einschwingverhalten der empfangsseitigen Schaltungsteile gegeben ist. Da sendeseitig die Pegel zur Bestimmung der verschiedenen Quantisierungsverzerrungen in entsprechenden Stufen geändert werden müssen, muß nach einer derartigen Änderung auf der Empfangsseite eine entsprechende Zeit vergehen, bis sich diese wieder für den neuen Pegel im eingeschwungenen Zustand befindet. Für entsprechend viele unterschiedliche Pegelstufen ergibt sich somit eine entsprechend aufsummierte »Wartezeit« für die verschiedenen aufeinander folgenden Einschwingvorgänge. Diese »Wartezeit« beeinträchtigt den Meßablauf ganz erheblich, insbesondere dann, wenn für die Erzielung einer ausreichend genauen Meßkurve sehr viele einzelne Meßpunkte angestrebt werden. Die Abhilfe für diese Schwierigkeit besteht darin, daß die Pegeländerung auf der Sendeseite und die Pegeländerung auf der Empfangsseite gegenläufig durchgeführt werden. D. h. für das vorliegende Beispiel, wenn das sendeseitige Dämpfungsglied am Anfang der Messung auf seinem Minimalwert liegt, dann liegt das empfangsseitige Dämpfungsglied ED auf seinem Maximalwert, während am Ende der Messung die umgekehrten Stellungen, d. h. sendeseitig Maximalwert und empfangsseitig ED Minimalwert erhalten werden. Im einzelnen erfolgt dabei die Einstellung der Pegelwerte so, daß in den beiden Meßzweigen der Empfangsseite bei den verschiedenen Messungen jeweils ein etwa konstanter Pegel vorliegt. Dadurch ergeben sich bei den Einstellungen der verschiedenen Pegelstufen auf der Sendeseite im Empfangsbereich keine unerwünschten Pegeländerungen mehr, die erst in der Art eines »Einschwingvorgangs« abgewartet werden müßten, um eine korrekte Messung durchführen zu können.

Diese Aussage gilt zumindest bezüglich der steuerbaren sendeseitigen und der empfangsseitigen Pegeländerungen; nicht eingeschlossen sind jedoch Änderungen, die durch die Quantisierungskennlinie der Übertragungseinrichtung PL selbst gegeben sind. Diese Änderungen sind in der Regel gering, d. h. sie sind bei fehlerfreien Systemen in der Größenordnung 1 bis 2 dB (innerhalb eines Pegelbereichs von annähernd 40 dB).

Aufgrund dieser Forderung, daß die Einstellung der Pegelwerte sende- und empfangsseitig gegenläufig vorgenommen werden muß, ist es erforderlich, daß zwischen der Sendeseite und der Empfangsseite eine gewisse Synchronisierung besteht. Hierfür können verschiedene bekannte Synchronisierungsverfahren eingesetzt werden. Im vorliegenden Beispiel ist angenommen, daß von der sendeseitigen Steuereinrichtung SST zu Beginn einer Messung (wie gestrichelt dargestellt) ein codiertes Startsignal auf die Übertragungseinrichtung PL gegeben wird. Auf der Empfangsseite ist eine entsprechende Decodierschaltung EC vorgesehen, in der das Startsignal decodiert und der empfangsseitigen Steuereinrichtung EST zugeführt wird. Diese weiß damit, daß nunmehr ein Meßvorgang beginnt und stellt das empfangsseitige Dämpfungsglied ED auf den für den Beginn der Messung vorgesehenen Anfangszustand ein. Ebenso ist natürlich sendeseitig das Dämpfungsglied SD auf den entsprechenden korrespondierenden Wert eingestellt. Der weitere Ablauf des Meßvorganges erfordert normalerweise keine zusätzliche Synchronisierung mehr, d. h. der einmalige Anstoß durch den Startimpuls bei Beginn der Messung genügt; die restliche Synchronisierung wird durch entsprechende Zeiteinrichtungen auf Sende- und Empfangsseite in Stufen entsprechend durchgeführt. Zwischen der sendeseitigen Steuereinrichtung SST und der Auswerteschaltung ist ebenfalls eine Verbindung hergestellt, wodurch die sendeseitig jeweils eingestellten Pegelwerte auch bei der Auswertung mit berücksichtigt werden können.

Anstelle der dargestellten Synchronisierung zwischen der Sende- und der Empfangsseite läßt sich auch vom Ausgang des Empfangsgleichrichters EG aus ein Startimpuls ableiten und zwar dann, wenn eine entsprechende Umschaltung z. B. von einer Frequenz innerhalb des Durchlaßbandes des EFQ-Filters auf eine Frequenz außerhalb dieses Durchlaßbandes umgeschaltet wird, wodurch eine entsprechende Zustandsänderung am Ausgang des Gleichrichters EG erhalten wird, welche als Startsignal herangezogen werden kann.

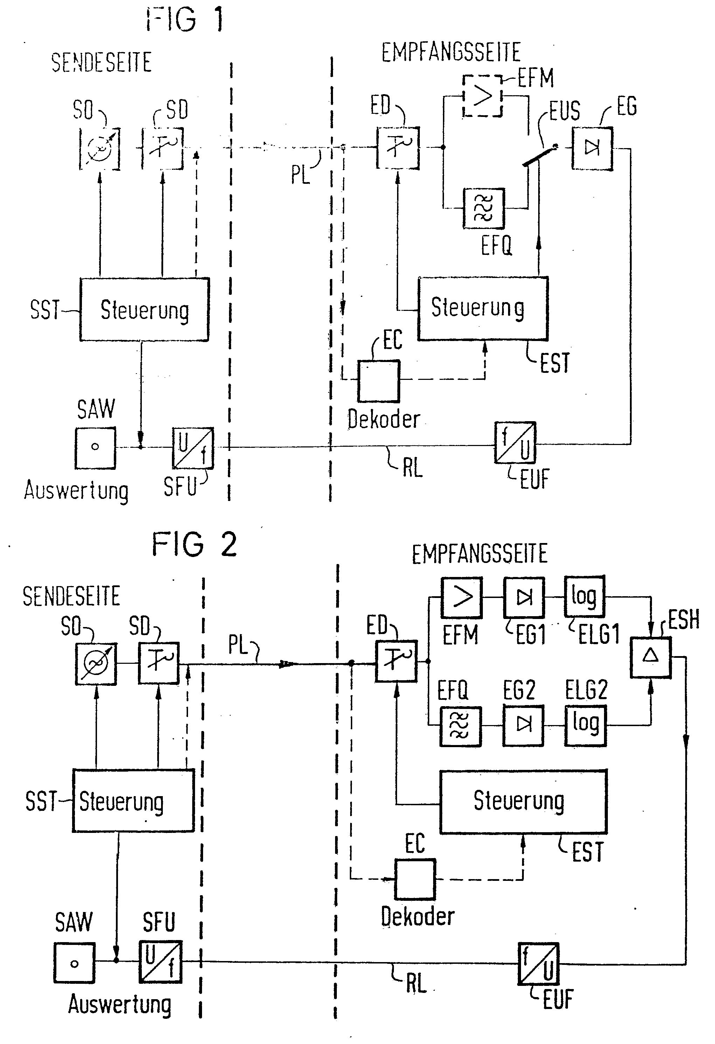

In Fig. 2 ist eine andere Ausführungsform zur Erläuterung der Erfindung dargestellt, wobei der Aufbau der Sendeseite gegenüber der Fig. 1 unverändert beibehalten wurde. Auch auf der Empfangsseite stimmt, wie durch die Übernahme der Bezugszeichen aus Fig. 1 angedeutet wurde, ein großer Teil der Schaltelemente überein, insbesondere das Dämpfungsglied ED, die Steuereinrichtung EST, der Decodierer EC sowie die beiden Empfangszweige mit den Schaltungsteilen EFM (erster Meßzweig) und das Filter im zweiten Meßzweig EFQ. Im Gegensatz zur Schaltung nach Fig. 1 ist jedoch nicht mehr ein gemeinsamer Gleichrichter für beide Meßzweige vorgesehen, sondern jeder Meßzweig enthält einen eigenen Gleichrichter und zwar EG 1 (Meßzweig 1) und EG 2 (Meßzweig 2). Dem Gleichrichter EG 1 ist eine Logarithmierschaltung ELG 1 nachgeschaltet, während beim Gleichrichter EG 2 eine Logarithmierschaltung ELG 2 vorgesehen ist. Auf diese Weise werden die logarithmierten Signale des Q-Bereiches und des ersten Meßbereiches unmittelbar einer Differenz-Schaltung (Subtraktionsstufe) ESH zugeführt, und damit der Pegelvergleich durchgeführt. Der so erhaltene Wert für die Pegeldifferenz wird in bekannter Weise zu der Sendeseite rückübertragen und dort entsprechend ausgewertet.

Bei der vorgeschlagenen Meßschaltung entsprechend Fig. 2 ist es zweckmäßig, wenn im ersten Meßzweig durch entsprechende Auslegung der Schaltung EFM sichergestellt wird, daß dort nur im wesentlichen das sendeseitige Meßsignal des Sendeoszillators SO also beispielsweise der Frequenzbereich um 430 Hz vorhanden ist.

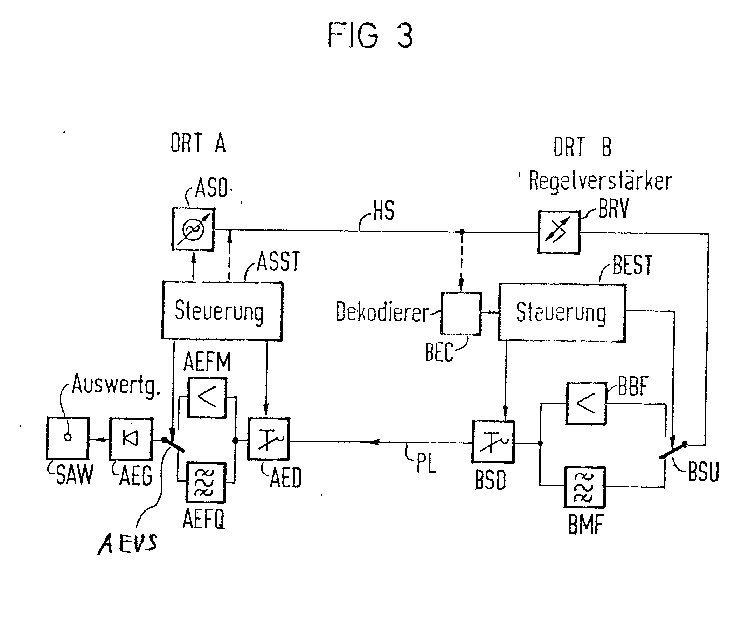

Bei der Schaltungsanordnung nach Fig. 3 ist angenommen, daß rückwärts gemessen wird, d. h. es soll vom Ort B aus die Übertragungsstrecke PL in Richtung auf den Ort A hin gemessen werden. Die Begriffe »Sendeseite« und »Empfangsseite« sind damit nicht mehr eindeutig definiert und es wurden deshalb die in den Fig. 1 und 2 verwendeten Bezeichnungen durch hinzufügen des Buchstabens A (für Ort A) bzw. des Buchstabens B (für den Ort B) ergänzt. Ansonsten ist der Aufbau und die Arbeitsweise der Schaltung weitgehend gegenüber den dortigen Ausführungsformen unverändert. An den Meßoszillator ASO ist eine Hilfsleitung HS angeschaltet, welche vom Ort A zum Ort B geführt ist und dort das Ausgangssignal des Meßsenders ASO einem Regelverstärker BRV zuführt. Anstelle eines entsprechenden Regelverstärkers BRV kann auch am Ort B ein eigener Generator vorgesehen sein, der vom Ort A aus durch ein entsprechendes Startsignal angestoßen wird und dann die Messung durchführt. Das so erhaltene, einen bestimmten Pegel aufweisende Signal wird über eine Umschalteinrichtung BSU zwei parallelen Übertragungswegen zugeführt, von denen der erste breitbandig ausgelegt und mit BBF bezeichnet ist. Dieser erste Übertragungsweg ist für das ganze interessierende Meßband durchlässig. Dagegen ist der zweite Übertragungsweg mit einem schmalbandigen Filter BMF versehen und läßt nur die eigentliche Meßfrequenz bzw. das eigentliche schmale Meßfrequenzband (z. B. 430 Hz) durch. Ausgangsseitig sind die beiden Übertragungswege zusammengeführt und einem gemeinsamen Dämpfungsglied BSD zugeleitet. Dieses Dämpfungsglied BSD führt, durch die zugehörige Steuereinrichtung BEST entsprechend eingestellt nacheinander die Einstellung der verschiedenen gewünschten Pegelwerte für die Durchführung des gesamten Meßvorgangs durch. Die so erhaltenen unterschiedlichen Pegelwerte werden nacheinander, wie bei Fig. 1 und 2 beschrieben, der Übertragungsstrecke PL zugeführt und gelangen daraufhin zu dem empfangsseitigen Dämpfungsglied AED. Dieses Dämpfungsglied AED wird ebenso bei den vorhergehenden Ausführungsbeispielen gegenläufig und gleichzeitig mit dem sendeseitigen Dämpfungsglied BSD betätigt. Die entsprechende Steuereinrichtung (über die Steuerung ASST, die Hilfsleitung HS, den Decodierer BEC und die Steuerung BEST) erfolgt in analoger Weise zu der Anordnung nach Fig. 1 und 2.

Nach dem Dämpfungsglied AED sind die beiden Meßzweige AEFM (erster Meßzweig) und AEFQ (zweiter Meßzweig) vorgesehen, deren Auslegung ebenfalls nach den in Zusammenhang mit den Figuren 1 und 2 besprochenen Gesichtspunkten erfolgt.

Wenn eine Ausführungsform mit entsprechenden Logarithmierschaltungen entsprechend Fig. 2 gewählt werden soll, dann ist der Aufbau der beiden Meßzweige entsprechend den Darstellungen der Meßzweige in Fig. 2 zu wählen. Über den ausgangsseitig angeordneten Umschalter AEUS wird die gemeinsame Gleichrichterschaltung AEG angesteuert und entsprechend das erhaltene Meßsignal der Auswerteschaltung SAW zur weiteren Verarbeitung und Darstellung zugeleitet.

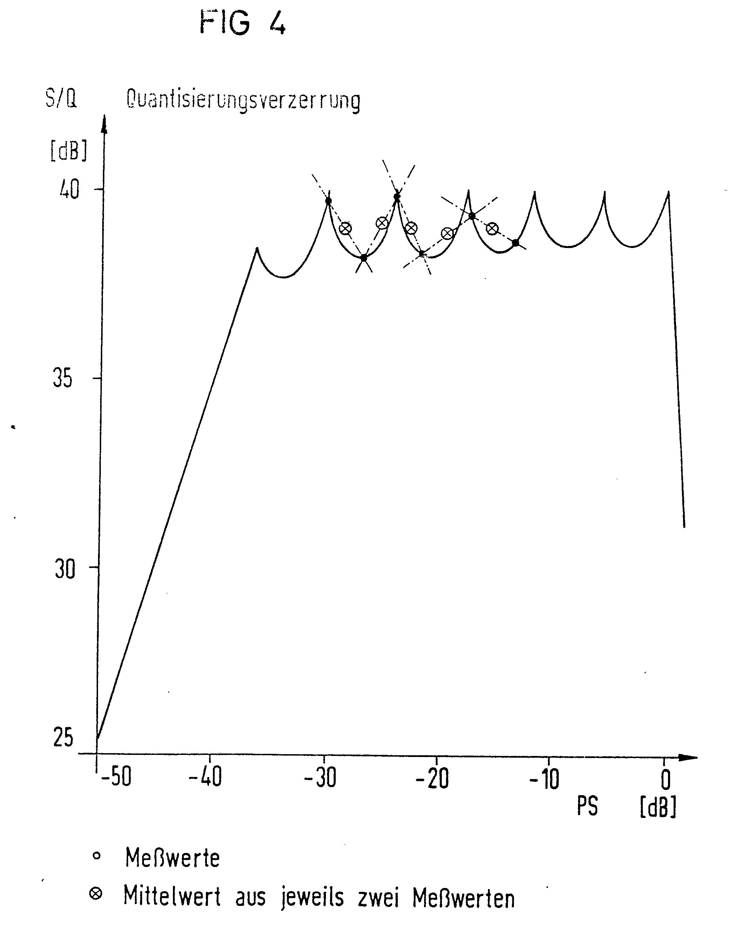

In Fig. 4 ist in einem Pegeldiagramm auf der Abszisse in dB die Amplitude des in das System (also die Übertragungseinrichtung PL nach Fig. 1 bis 3) eingespeisten Signals PS aufgetragen. Auf der Ordinate ist das Verhältnis von S/Q angegeben, wobei S der Pegel des Meßsignals und Q

das durch die Übertragungseinrichtung verursachte und auf der Empfangsseite erhaltene Quantisierungsgeräusch darstellt. Das Verhältnis S/Q entspricht somit dem Signal-(Quantisierungs)-Geräusch-Abstand.

Die dargestellte Kurve zeigt den Verlauf bei Messung mit einer Sinusschwingung, d. h. von dem Generator SO nach Fig. 1 bis 3 wird ein Sinus-Signal z. B. der Frequenz 430 Hz abgegeben. Aus der nur in ihrer Grobstruktur wiedergegebenen Kurve ist ersichtlich, daß die Meßkurve in Abhängigkeit vom Eingangssignal PS gewissen etwa periodischen Schwankungen unterliegt. Diese Schwankungen würden nicht auftauchen, wenn man anstelle eines Sinussignals zur Messung ein Rauschsignal benutzen würde. Die Verwirklichung eines Rauschgenerators anstelle eines Sinusgenerators entsprechend den Fig. 1 bis 3 ist jedoch wesentlich aufwendiger.

Gemäß der Erfindung kann durch eine entsprechend gewählte Stufung in den Pegelwerten des Meßsignals (also durch eine entsprechend gestufte Einstellung der Dämpfung des Dämpfungsgliedes SD) und nachfolgende Mittelwertbildung aus zwei benachbarten Meßwerten ein Meßergebnis erzielt werden, welches dem sehr ähnlich ist, welches beim Einsatz eines Rauschgenerators erzielt wird. Dabei ist so vorzugehen, daß die Stufung des Meßsignals so vorgenommen wird, daß die einzelnen Meßwerte etwa bei der halben Periodizität der Meßkurve liegen. Im dargestellten Beispiel wird dies dadurch erreicht, daß das Sendesignal PS in Stufen von etwa 3 dB verändert wird. Die dabei erzielten Meßwerte sind durch dicke schwarze Punkte angedeutet. Nimmt man zwischen zwei jeweils aufeinanderfolgende, durch schwarze Punkte angedeuteten Meßwerten den Mittelwert (angedeutet durch ein Kreuz in einem Kreis), so ergibt die Folge der in den Kreisen angegebenen Kreuze etwa den Verlauf der Meßkurve, den man erhalten würde, wenn mit einer Rauschsignalquelle gemessen würde. Auf diese Weise läßt sich also der schaltungsmäßige Aufwand bedeutend vereinfachen.

**Patentansprüche**

1. Verfahren zur Ermittlung der von einer PCM-Übertragungseinrichtung bewirkten Quantisierungsverzerrung eines übertragenen Signals in Abhängigkeit vom Pegel dieses Signals, bei dem

— die Übertragungseinrichtung senderseitig mit einem sinusförmigen Signal einer gegebenen Frequenz beaufschlagt wird,
— empfangsseitig zwei parallele Kanäle vorgesehen werden, von denen der eine auf die gegebene Frequenz und der andere auf ein die gegebene Frequenz nicht enthaltendes Frequenzband abgestimmt wird,
— sende- und empfangsseitig eine gleichzeitige gegenläufige Pegeleinstellung derart vorgenommen wird, daß der Pegel in den beiden Kanälen bei einer Veränderung des Pegels des sinusförmigen Signals im wesentlichen konstant bleibt, und
— die sich für einen jeweils unterschiedlichen Pegel des sinusförmigen Signals ergebenden Ausgangspegel der beiden Kanäle gemessen und zur Ermittlung der eine Periodizität aufweisenden Abhängigkeit der Quantisierungsverzerrung von dem Pegel des sinusförmigen Signals verwendet werden,

dadurch gekennzeichnet, daß

— die senderseitige Einstellung des Pegels des sinusförmigen Signals in solchen Stufen erfolgt, daß die Meßwerte für die Quantisierungsverzerrung etwa im Abstand der halben Periodizität der Abhängigkeit der Quantisierungsverzerrung von diesem Pegel erhalten werden, und
— jeweils der Mittelwert zwischen zwei benachbarten Meßwerten gebildet wird.

2. Verfahren nach Anspruch 1, dadurch gekennzeichnet, daß die Einstellung des Pegels des sinusförmigen Signals etwa in 3 dB-Stufen vorgenommen wird.

**Claims**

1. Method of determining the quantization distortion of a transmitted signal produced by a PCM transmission device, in dependence upon the level of this signal, wherein

— at the transmitting end the transmission device is fed with sinusoidal signal of a given frequency,
— at the receiving end, there are arranged two parallel channels one of which is tuned to the given frequency and the other of which is tuned to a frequency band which does not include the given frequency,
— at the transmitting and receiving ends a simultaneous oppositely directed level adjustment is effected in such a manner that in the event of a change in the level of the sinusoidal signal the level in the two channels substantially remains constant, and
— the output levels of the two channels which arise for a different level of the sinusoidal signal are measured and used for determining the dependence on the level of the sinusoidalsignal, of the quantisation distortion, which has a periodicity,

characterised in that

— the transmitting-end adjustment of the level of the sinusoidal signal is effected in such stages that the measured values for the quantisation distortion are approximately obtained at intervals of half the periodicity of the dependence of the quantisation distortion on this level, and
— the mean value is respectively formed between two adjacent measured values.

2. Method as claimed in Claim 1, characterised in that the adjustment of the level of the sinusoidal signal is approximately effected in 3 dB-stages.

**Revendications**

1. Procédé pour déterminer la distance de quantification, provoquée par un dispositif de transmission PCM, d'un signal transmis, en fonction du niveau de ce signal, dans lequel

— le dispositif de transmission reçoit côté émission un signal sinusoïdal de fréquence donnée,
— il est prévu côte réception deux canaux parallèles dont un est accordé sur la fréquence donnée et dont l'autre est accordé sur une bande de fréquences ne contenant pas la fréquence donnée,
— côté émission et côté réception est effectué un réglage de niveau simultané en sens contraire de manière que le niveau reste sensiblement constant dans les deux canaux lors d'une variation du niveau du signal sinusoïdal, et
— les niveaux de sortie, apparaissant pour un niveau respectivement différent du signal sinusoïdal, des deux canaux sont mesurés et utilisés pour déterminer la dépendance, présentant une périodicité, de la distorsion de quantification vis-à-vis du niveau du signal sinusoïdal,

caractérisé par le fait que

— le réglage côté émission du niveau du signal sinusoïdal a lieu par paliers tels que les valeurs mesurées pour la distorsion de quantification sont obtenues sensiblement à un écart de la moitié de la périodicité de la dépendance de la distorsion de quantification par rapport à ce niveau, et
— il est formé la valeur moyenne entre deux valeurs mesurées voisines.

2. Procédé suivant la revendication 1, caractérisé par le fait que le réglage du niveau du signal sinusoïdal est effectué sensiblement par paliers de 3 dB.

## FIG 1

SENDESEITE

EMPFANGSSEITE

SO SD

ED EFM EUS EG

PL

EFQ

SST Steuerung

Steuerung

EST

EC

SAW

Dekoder

Auswertung U/f SFU

RL f/U EUF

## FIG 2

SENDESEITE

EMPFANGSSEITE

SO SD

PL ED EFM EG1 ELG1 ESH

EFQ EG2 ELG2

SST Steuerung

Steuerung

EST

EC

SAW SFU

Dekoder

Auswertung U/f

RL f/U EUF

# FIG 3

ORT A

ORT B

Regelverstärker

# FIG 4

S/Q    Quantisierungsverzerrung

[dB]

○    Meßwerte

⊗    Mittelwert aus jeweils zwei Meßwerten